(19) Europäisches Patentamt / European Patent Office / Office européen des brevets

(11) **EP 4 391 286 A1**

(12) **EUROPEAN PATENT APPLICATION**

(43) Date of publication:
26.06.2024 Bulletin 2024/26

(51) International Patent Classification (IPC):
*H02J 7/00* *(2006.01)*

(21) Application number: 23189080.7

(22) Date of filing: 01.08.2023

(52) Cooperative Patent Classification (CPC):
H02J 7/0071; H02J 7/007182

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: 23.12.2022 KR 20220182666

(71) Applicant: Samsung Electronics Co., Ltd.
Suwon-si, Gyeonggi-do 16677 (KR)

(72) Inventors:
• **Jung, Daeryong**
**16678 Suwon-si, Gyeonggi-do (KR)**
• **Kim, Jinho**
**16678 Suwon-si, Gyeonggi-do (KR)**

(74) Representative: **Grünecker Patent- und Rechtsanwälte**
**PartG mbB**
**Leopoldstraße 4**
**80802 München (DE)**

(54) **METHOD AND APPARATUS WITH BATTERY PARAMETER OPTIMIZATION FOR TARGET BATTERY**

(57) A method of determining an optimized value set of parameters for a target operation of a battery includes: setting a first value set of the respective parameters as a default value set; acquiring a first performance indicator by performing a simulation of the target operation according to the first value set; generating candidate second value sets having at least one value in the first value set changed; acquiring second performance indicators respectively corresponding to the candidate second value sets by performing simulations of the target operation according to the respective candidate second value sets; selecting one of the candidate second value sets as a second value set based on the second performance indicators; determining that the second performance indicator corresponding to the second value set satisfies a performance condition of the battery, and in response using the second value set as the optimized value set of the parameters.

FIG. 1

**EP 4 391 286 A1**

**Description**

BACKGROUND

1. Field

The following description relates to a technology for determining a parameter value of a battery applied when a predetermined operation is performed on the battery, and more particularly, to a technology for determining a set of optimal values of parameters of a battery.

2. Description of Related Art

Batteries are charged using various methods. For example, a constant current-constant voltage (CC-CV) charging method initially charges a battery with a constant current, and then charges the battery at a constant voltage when a voltage of the battery reaches a preset level. A varying current decay charging method charges a battery with high current at a low state of charge (SOC), and gradually reduces the current when the battery has a predetermined SOC that is reached by the charging. In addition to the aforementioned methods, a multi-step charging method charges a battery with constant currents, and a pulse charging method charges a battery by repeatedly applying pulse currents at short time intervals.

SUMMARY

The invention is claimed in the independent claims. Preferred embodiments are specified in the dependent claims.

In one general aspect, a method of determining an optimized value set of parameters used for a target operation of a battery includes: setting, as a default value set, a first value set including first values of the respective parameters; acquiring a first performance indicator by performing a simulation of the target operation according to the first value set; generating candidate second value sets, each candidate second value set having at least one value in the first value set changed based on the first value set; acquiring second performance indicators respectively corresponding to the candidate second value sets by performing simulations of the target operation according to the respective candidate second value sets; selecting one of the candidate second value sets as a second value set based on the second performance indicators; determining whether the second performance indicator corresponding to the second value set satisfies a target performance condition of the battery; and in response to determining that the second performance indicator satisfies the target performance condition of the battery, using the second value set as the optimized value set of the parameters.

The acquiring of the first performance indicator may include performing the simulation of the target operation by applying the first value set to a battery model representing an internal state of the battery.

The target operation may be an operation of charging the battery.

The target performance indicator may include a charging capacity of the battery and/or a charging speed of the battery.

The generating of the candidate second value sets may include: generating a first second candidate value set by changing a first value of a first of the parameters to a second value based on a preset variation for the first parameter; and generating a second second candidate value set by changing a first value of a second of the parameters to a second value based on a preset variation for the second parameter.

The generating of the candidate second value sets may include: determining a variation of the first value of the first parameter based on a first lookup table (LUT) preset for the first parameter; generating a first second candidate value set by changing the first value of the first parameter to a second value based on the variation of the first value of the first parameter; determining a variation of the first value of the second parameter based on a second LUT preset for the second parameter among the parameters; and generating a second second candidate value set by changing the first value of the second parameter to a second value based on the variation of the first value of the second parameter.

The generating of the candidate second value sets may include: determining a variation of the first value of the first parameter based on a first function preset for the first parameter; generating a first second candidate value set by changing the first value of the first parameter to a second value based on the variation of the first value of the first parameter; determining a variation of the first value of the second parameter based on a second function preset for the second parameter among the parameters; and generating a second second candidate value set by changing the first value of the second parameter to a second value based on the variation of the first value of the second parameter.

The acquiring of the first performance indicator may include acquiring the first performance indicator based on a result value of a first factor of the simulation, a first weight of the first factor, a result value of a second factor of the simulation, and a second weight of the second factor.

The method may further include, in response to the second performance indicator not satisfying the target performance condition, setting the second value set as a new default set of the parameters.

In one general aspect, an electronic device for determining an optimized value set of parameters used for a target operation of a battery includes: one or more processors; and a memory storing instructions configured to cause the one or mor processors to: access simulation data for preset charging currents that is based on a battery model representing an internal state of the battery; set a first value set as a default value set of the parameters; acquire a first performance indicator by performing a simulation of the target operation of the battery based on the first value set and the simulation data; generate a candidate second value sets in which at least one value in the first value set is changed based on the first value set; acquire candidate second performance indicators by performing simulations of the target operation of the battery based on the respective candidate second value sets and the simulation data; determine one of the candidate second value sets as a second value set of the parameters based on the candidate second performance indicators; determine whether the second performance indicator for the second value set of the parameters corresponds to a preset target performance indicator; and in response to the second performance indicator corresponding to the target performance indicator, determine the second value set to be the optimized value set of the parameters.

The target operation may be an operation of charging the battery.

The target performance indicator may include a charging capacity and/or a charging speed of the battery.

The generating of the candidate second value sets may include: generating a first second candidate value set by changing a first value of a first of the parameter to a second value based on a preset variation for the first parameter; and generating a candidate second second value set by changing a first value of a second of the parameters to a second value based on a preset variation for the second parameter.

The preset variation for the first parameter and the preset variation for the second parameter may include different respective values.

The generating of the candidate second value sets may include: determining a variation of the first value of the first parameter based on a first lookup table (LUT) preset for the first parameter; generating a first second candidate value set by changing the first value of the first parameter to a second value based on the variation of the first value of the first parameter; determining a variation of the first value of the second parameter based on a second LUT preset for the second parameter; and generating a second second candidate value set by changing the first value of the second parameter to a second value based on the variation of the first value of the second parameter.

The generating of the candidate second value sets may include: determining a variation of the first value of the first parameter based on a first function preset for the first parameter; generating a first second candidate value set by changing the first value of the first parameter to a second value based on the variation of the first value of the first parameter; determining a variation of the first value of the second parameter based on a second function preset for the second parameter; and generating a second second candidate value set by changing the first value of the second parameter to a second value based on the variation of the first value of the second parameter.

The acquiring of the first performance indicator is based on a result value of a first factor of the simulation, a first weight of the first factor, a result value of a second factor of the simulation, and a second weight of the second factor.

The instructions may be further configured to cause the one or more processors to: in response to the second performance indicator not corresponding to the target performance indicator, set the second value set as the default set of the parameters, and generate new candidate second value sets in which at least one value in the first value set is changed based on the first value set.

In another general aspect, a method includes: forming a first battery parameter values set; generating first permutation sets including respective permutations of the first battery parameter values set; obtaining first performance indications generated by respective simulations of an internal state of a battery based on the respective first permutation sets; based on the first performance indications, determining that none of the first permutation sets satisfy a performance condition of a charging operation of the battery, and based thereon, generating second permutations sets including respective permutations of one of the first permutation sets; obtaining second performance indications generated by respective simulations of the internal state of the battery based on the respective second permutation sets; and selecting one of the second permutation sets based on its corresponding second performance indication, and using the selected second permutation set to control a charging operation of the battery.

The one of the second permutation sets may be selected based on having the highest corresponding second performance indication.

The method as described above, and any associated data, data files, and data structures, may be recorded, stored, or fixed in or on one or more non-transitory computer-readable storage media. Accordingly, there is provided a computer-readable storage medium having instructions that, when executed by one or more processors, cause the one or more processor to perform the steps of: forming a first battery parameter values set; generating first permutation sets including respective permutations of the first battery parameter values set; obtaining first performance indications generated by respective simulations of an internal state of a battery based on the respective first permutation sets; based on the first performance indications, determining that none of the first permutation sets satisfy a performance condition of a charging operation of the battery, and based thereon, generating second permutations sets including respective permutations of one of the first permutation sets; obtaining second performance indications generated by respective simulations of the internal state of the battery based on the respective second permutation sets; and selecting one of the second permutation sets based on its corresponding second performance indication, and using the selected second permutation set to control a charging operation of the battery.

Other features and aspects will be apparent from the following detailed description, the drawings, and the claims.

BRIEF DESCRIPTION OF THE DRAWINGS

FIG. 1 illustrates an example configuration of an electronic device, according to one or more embodiments.

FIG. 2 illustrates an example method of determining an optimal value set of parameters, according to one or more embodiments.

FIG. 3 illustrates an example method of generating a candidate second value sets, according to one or more embodiments.

FIG. 4 illustrates an example method of generating second candidate value sets based on preset variations for each of parameters, according to one or more embodiments.

FIG. 5 illustrates an example method of generating a candidate second value sets based on variations determined based on a preset lookup table (LUT) for each of parameters, according to one or more embodiments.

FIG. 6 illustrates an example method of generating candidate second value sets based on variations determined based on a preset function for each of parameters, according to one or more embodiments.

FIG. 7 illustrates an example method of determining a second value set of parameters as a default set, according to one or more embodiments.

FIG. 8 illustrates example simulation results for an operation of charging a battery at a current rate (C-rate) of 5C using a parameter variation table, according to one or more embodiments.

FIG. 9 illustrates an example variation curve of cell voltage as a first factor used to obtain a performance indicator for an operation of charging a battery, according to one or more embodiments.

FIG. 10 illustrates an example variation curve of anode potential as a second factor used to obtain a performance indicator for an operation of charging a battery, according to one or more embodiments.

FIGS. 11 to 15 illustrate examples of simulation results of an operation of charging a battery at a C-rate of 5C according to variations of a first weight for a first factor and variations of a second weight for a second factor, according to one or more embodiments.

Throughout the drawings and the detailed description, unless otherwise described or provided, the same or like drawing reference numerals will be understood to refer to the same or like elements, features, and structures. The drawings may not be to scale, and the relative size, proportions, and depiction of elements in the drawings may be exaggerated for clarity, illustration, and convenience.

DETAILED DESCRIPTION

The following detailed description is provided to assist the reader in gaining a comprehensive understanding of the methods, apparatuses, and/or systems described herein. However, various changes, modifications, and equivalents of the methods, apparatuses, and/or systems described herein will be apparent after an understanding of the disclosure of this application. For example, the sequences of operations described herein are merely examples, and are not limited to those set forth herein, but may be changed as will be apparent after an understanding of the disclosure of this application, with the exception of operations necessarily occurring in a certain order. Also, descriptions of features that are known after an understanding of the disclosure of this application may be omitted for increased clarity and conciseness.

The features described herein may be embodied in different forms and are not to be construed as being limited to the examples described herein. Rather, the examples described herein have been provided merely to illustrate some of the many possible ways of implementing the methods, apparatuses, and/or systems described herein that will be apparent after an understanding of the disclosure of this application.

The terminology used herein is for describing various examples only and is not to be used to limit the disclosure. The articles "a," "an," and "the" are intended to include the plural forms as well, unless the context clearly indicates otherwise. As used herein, the term "and/or" includes any one and any combination of any two or more of the associated listed items. As non-limiting examples, terms "comprise" or "comprises," "include" or "includes," and "have" or "has" specify the presence of stated features, numbers, operations, members, elements, and/or combinations thereof, but do not preclude the presence or addition of one or more other features, numbers, operations, members, elements, and/or combinations thereof.

Throughout the specification, when a component or element is described as being "connected to," "coupled to," or "joined to" another component or element, it may be directly "connected to," "coupled to," or "joined to" the other component or element, or there may reasonably be one or more other components or elements intervening therebetween. When a component or element is described as being "directly connected to," "directly coupled to," or "directly joined to" another component or element, there can be no other elements intervening therebetween. Likewise, expressions, for example, "between" and "immediately between" and "adjacent to" and "immediately adjacent to" may also be construed as described in the foregoing.

Although terms such as "first," "second," and "third", or A, B, (a), (b), and the like may be used herein to describe various members, components, regions, layers, or sections, these members, components, regions, layers, or sections are not to be limited by these terms. Each of these terminologies is not used to define an essence, order, or sequence of corresponding members, components, regions, layers, or sections, for example, but used merely to distinguish the corresponding members, components, regions, layers, or sections from other members, components, regions, layers, or sections. Thus, a first member, component, region, layer, or section referred to in the examples described herein may also be referred to as a second member, component, region, layer, or section without departing from the teachings of the examples.

Unless otherwise defined, all terms, including technical and scientific terms, used herein have the same meaning as commonly understood by one of ordinary skill in the art to which this disclosure pertains and based on an understanding of the disclosure of the present application. Terms, such as those defined in commonly used dictionaries, are to be interpreted as having a meaning that is consistent with their meaning in the context of the relevant art and the disclosure of the present application and are not to be interpreted in an idealized or overly formal sense unless expressly so defined herein. The use of the term "may" herein with respect to an example or embodiment, e.g., as to what an example or embodiment may include or implement, means that at least one example or embodiment exists where such a feature is included or implemented, while all examples are not limited thereto.

In general, in a battery development process, a target performance indicator for a battery is set in advance. For example, the target performance indicator may include an indicator related to a charging capacity achieved under preset charging conditions (e.g., a charging temperature, a current rate (C-rate) of a battery) and an indicator related to a charging rate. The performance of a battery may be influenced, for example, by parameters of physical properties of materials used in manufacturing the battery or parameters of the structural design of the battery. There may be many parameters that affect the performance of a battery. Accordingly, finding a combination of optimal values for respective parameters (of which there may be many) used for a target operation (e.g., charging or discharging) of a battery may be difficult.

Improving the characteristics of only one element (e.g., an electrolyte) or a predetermined parameter (e.g., ionic conductivity of an electrolyte) of a battery may be insufficient to achieve a target performance indicator of the battery. In order to have a target operation achieve a target performance indicator of the battery, a process of finding a combination of optimal values of parameters within a feasible range may be used to improve overall characteristics of the battery.

When a computationally efficient calculation algorithm (or model) is not used in the process of finding a combination of optimal values of parameters, the number of simulation runs of different combinations of candidate values may increase exponentially as the number of the parameters of which the candidate values can be changed increases. For example, when the number of parameters is 12 and each of the parameters may be adjusted to 10 different levels, absent some optimization technique, $10^{12}$ simulations may have to be performed to find the optimal combination of values of the respective parameters.

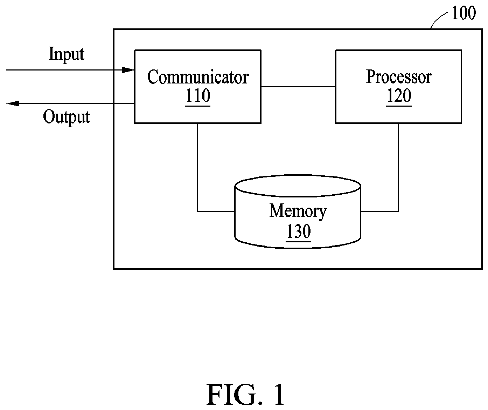

In the following description, methods of finding a combination of optimal values of respective parameters is described in detail with reference to FIGS. 1 to 12. As used herein, "optimal" does not refer to the "most optimal" set of values (maximally optimal), but rather refers to a set of values optimized to some extent (i.e., "optimal", but not "the optimum").

FIG. 1 illustrates an example configuration of an electronic device 100, according to one or more embodiments. The electronic device 100 may include a communicator 110, a processor 120, and a memory 130. For example, the electronic device 100 may be an electronic device or a server for determining an optimal value set of parameters used for a target operation of a battery.

The communicator 110 may be connected to the processor 120 and the memory 130 to transmit and receive data to and from the processor 120 and the memory 130. The communicator 110 may be connected to another external device to transmit and receive data to and from the external device. Hereinafter, transmitting and receiving "A" may refer to transmitting and receiving "information or data that indicates A".

The communicator 110 may be implemented as circuitry in the electronic device 100. For example, the communicator 110 may include an internal bus and/or an external bus. As another example, the communicator 110 may be an element that connects the electronic device 100 to an external device. The communicator 110 may be an interface (e.g., a bus interface, a network interface card, etc.). The communicator 110 may receive data from the external device and transmit the data to the processor 120 and the memory 130.

The processor 120 may process the data received by the communicator 110 and data stored in the memory 130. A "processor" may be a hardware-implemented data processing device having a physically structured circuit to execute desired operations. For example, the desired operations may include code or instructions included in a stored program. For example, the hardware-implemented data processing device may include a microprocessor, a central processing unit (CPU), a processor core, a multi-core processor, a multiprocessor, an application-specific integrated circuit (ASIC), and a field-programmable gate array (FPGA). As used herein "processor" refers to any combination of one or more processing elements (processing hardware), e.g., CPU(s), graphics processing unit(s) (GPUs), FPGA(s), etc.

The processor 120 may execute computer-readable code (e.g., instructions) stored in a memory (e.g., the memory 130) and instructions triggered or generated by the processor 120.

The memory 130 may store data received by the communicator 110 and data processed by the processor 120. For example, the memory 130 may store the program (or an application, or software, in the form of instructions). For example, the stored program may be a set of statements with syntax of a programming language that are translated/interpreted to instructions executable by the processor 120 to determine an optimal value set of parameters to be used when performing a target operation of a battery.

The memory 130 may include, for example, any one or any combination of a volatile memory, a non-volatile memory, a random-access memory (RAM), a flash memory, a hard disk drive, and an optical disc drive.

The memory 130 may store an instruction set (e.g., software) for operating the electronic device 100. The instruction set for operating the electronic device 100 may be executed by the processor 120.

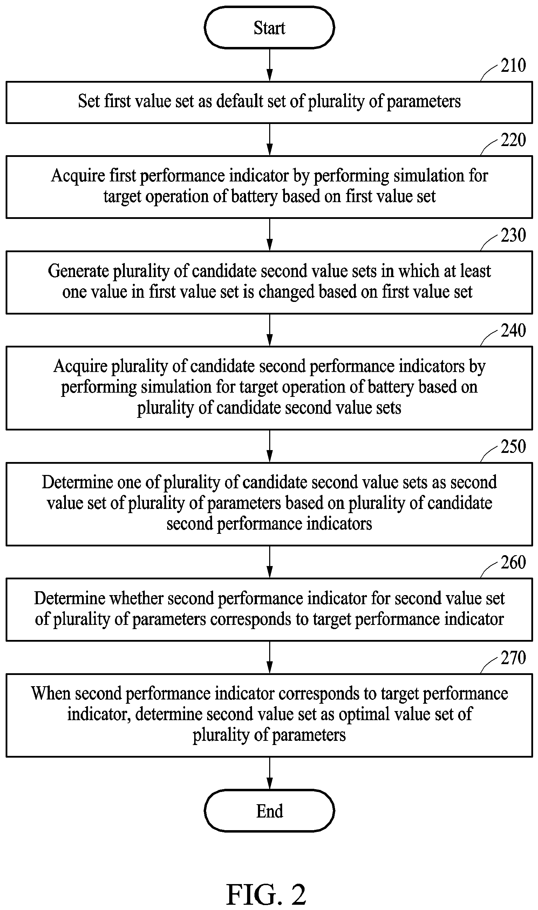

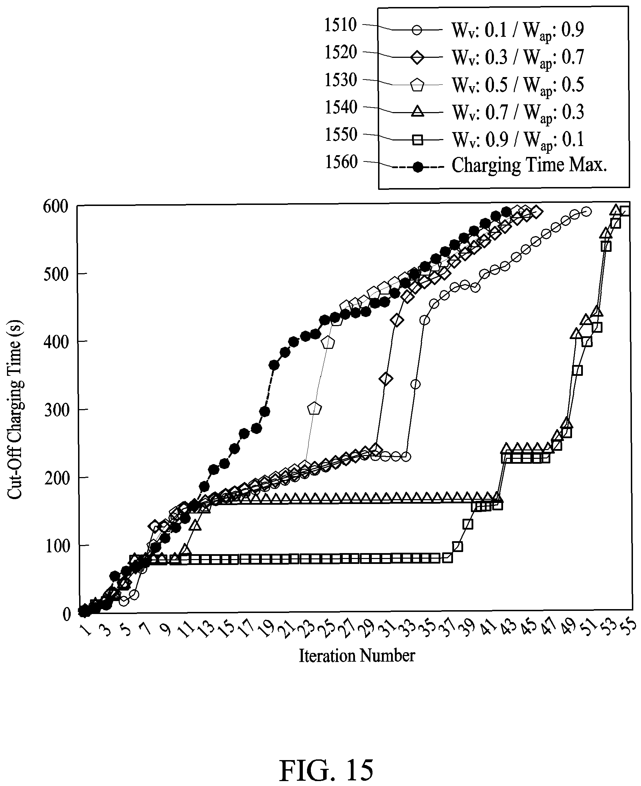

The communicator 110, the processor 120, and the memory 130 are described further with reference to FIGS. 2 and 15.

FIG. 2 illustrates an example method of determining an optimal value set of parameters, according to one or more embodiments.

Operations 210 to 270 may be performed by the electronic device 100 described above with reference to FIG. 1.

In operation 210, the electronic device 100 may set a first value set (set of values) as a default set of values for parameters used for performing a target operation of a battery. The battery may be a rechargeable battery. For example, the battery may be a lithium-ion battery, a lithium-based solid-state battery, a lithium-air battery, a sodium-ion battery, or the like. Each of the parameters may be a parameter applicable to an electrochemical-thermal (ECT) model (e.g., a parameter of an ECT model). For example, the target operation may be an operation of charging the battery or discharging the battery.

For example, the parameters may include at least two of parameters respectively representing at least two of: a porosity in an anode electrode layer (or a volume fraction of an electrolyte in the anode electrode layer), a porosity of a separator (or a volume fraction of an electrolyte in the separator), a porosity in a cathode electrode layer (or a volume fraction of an electrolyte in the cathode electrode layer), surface film resistance of an anode active material, surface film resistance of a cathode active material, a diffusion coefficient of lithium-ions in an anode active material, a diffusion coefficient of lithium-ions in a cathode active material, a lithium-ion reaction rate constant on an anode surface, a lithium-ion reaction rate constant on a cathode surface, a lithium-ion transference number in an electrolyte, a diffusion coefficient of lithium-ions in an electrolyte, and ionic conductivity of an electrolyte.

In an example, values of the default value set (also referred to as the first value set) of the parameters may be starting/initial values for determining the values of the to-be-determined optimal value set. For example, values in the first value set of the parameters may be values of a battery that is in commercial use. For example, the values in the first value set may be arbitrary or random values.

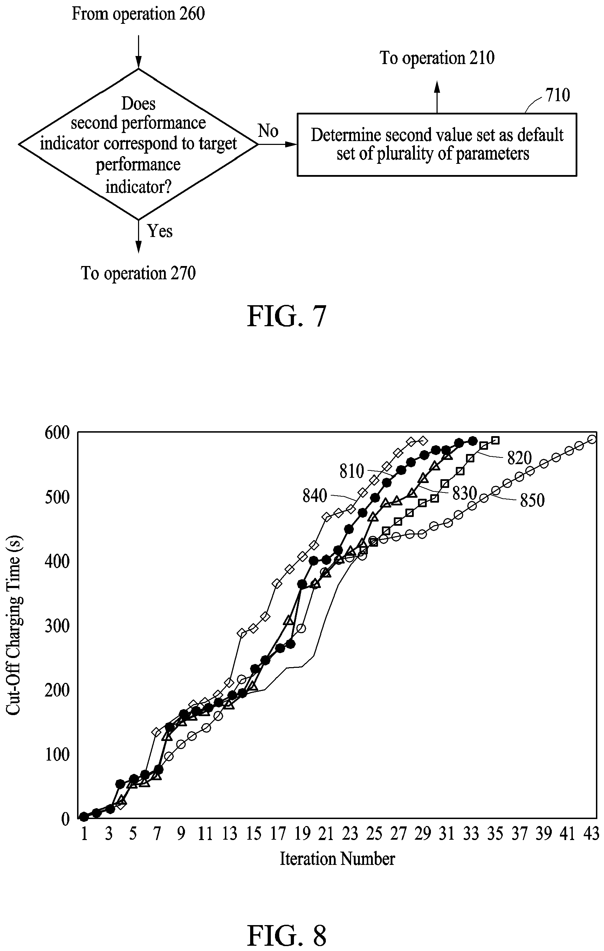

In an example, the default value set may be a second value set determined by operation 710 (described with reference to FIG. 7). A method of determining the second value set as the default value set is described with reference to FIG. 7.

In operation 220, the electronic device 100 may acquire a first performance indicator by performing a simulation of the target operation of the battery based on the first value set of the parameters. The electronic device 100 may perform a simulation for the target operation by applying the first value set to a battery model representing an internal state of the battery. For example, when the target operation is an operation of charging the battery under preset conditions, the electronic device 100 may simulate charging state of the battery by applying the values of the first value set to the ECT model (e.g., parameters of the ECT model may be set to the respective values of the first value set). The electronic device 100 may acquire (or calculate) a performance indicator for a performance to be confirmed based on a result of the simulation. For example, the performance indicator may include an indicator related to (or indicating) charging capacity and an indicator related to (or indicating) charging speed.

In operation 230, the electronic device 100 may generate candidate second value sets in each of which at least one value in the first value set is changed based on (or changed from) the first value set.

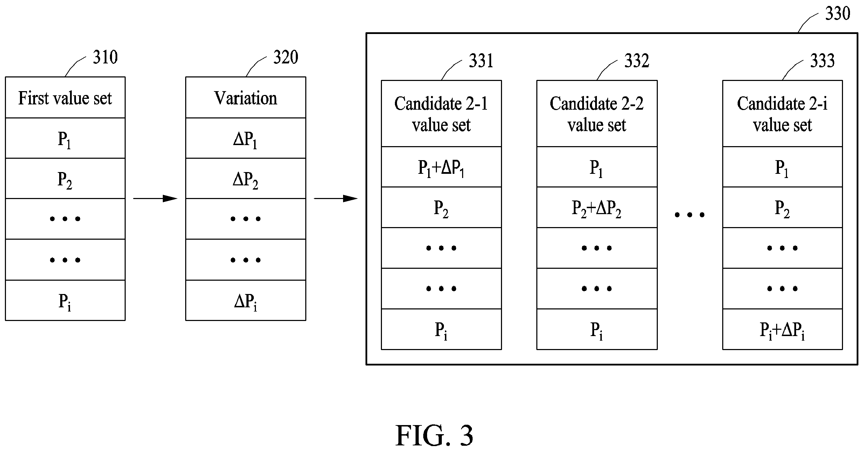

For example, when the number of the plurality of parameters is i, the number of the candidate second value sets may be i, and each of the candidate second value sets may include values in which at least one of the default values is changed. Each of the plurality of candidate second value sets may differ in at least one value from each other. In other words, each candidate second value set may be a version of the first/default value set, but with at least one value changed. A method of generating the candidate second value sets is described with reference to FIGS. 3 to 6.

In operation 240, the electronic device 100 may acquire second performance indicators by performing simulations of the target operation of the battery based for the respective candidate second value sets. For example, referring to FIG. 3, a candidate 2-1 performance indicator may be acquired based on a simulation result for a candidate 2-1 value set, and a candidate 2-2 performance indicator may be acquired based on a simulation result for a candidate 2-2 value set.

In operation 250, the electronic device 100 may determine or select one of the candidate second value sets as the second value set of the parameters based on the second performance indicators.

In an example, the candidate second value set having the highest performance indicator among the candidate second value sets may be determined/selected as the second value set of the parameters.

In operation 260, the electronic device 100 may determine whether the second performance indicator for the second value set of the plurality of parameters corresponds to (or satisfies) a target performance indicator (or target performance condition). For example, the target performance indicator may include any one of, or any combination of, a charging capacity or a charging speed of the battery with respect to charging of the battery.

For example, when the second performance indicator is greater than or equal to the target performance indicator, the electronic device 100 may determine that the second performance indicator corresponds to the target performance indicator.

In operation 270, when the second performance indicator corresponds to the target performance indicator, the electronic device 100 may determine/select the second value set as an optimal value set of the parameters. For example, the determined optimal value set may be used by any electronic device (e.g., a mobile communication terminal or a vehicle) including a battery to perform the previously-simulated target operation with respect to the battery. For example, when a battery is used as a power source of a vehicle, a processor of the vehicle (or a battery controller) may use the optimal value set of the parameters to control performing an operation of charging the battery of the vehicle.

An operation of the electronic device 100 performed when the second performance indicator does not correspond to the target performance indicator is also described in detail with reference to FIG. 7 below.

FIG. 3 illustrates an example method of generating candidate second value set, according to one or more embodiments.

The number of parameters may be represented as i, and values of a first value set 310 of the i parameters may include first values $P_1$, $P_2$,..., $P_i$ of the respective parameters.

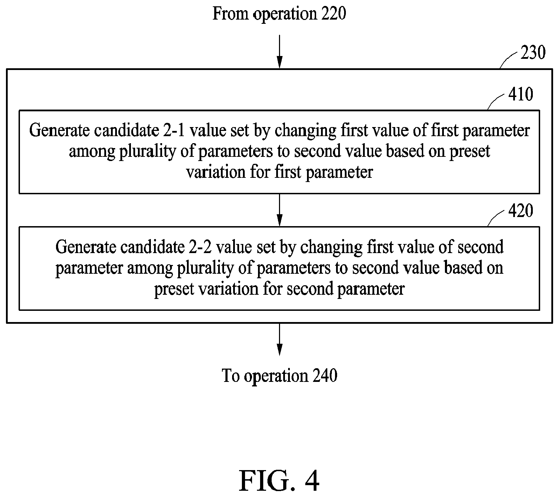

In an example, the electronic device 100 may determine a variation set 320 for the first value set 310. The variation set 320 may include variations $\Delta P_1$, $\Delta P_2$,..., $\Delta P_i$ of the respective first values $P_1$, $P_2$,..., $P_i$ of the parameters. For example, each of the variations $\Delta P_1$, $\Delta P_2$,..., $\Delta P_i$ may be preset for a corresponding parameter. For example, each of the variations $\Delta P_1$, $\Delta P_2$,..., $\Delta P_i$ may be determined based on a lookup table (LUT) preset for a corresponding parameter (e.g., Table 1 below). For example, each of the variations $\Delta P_1$, $\Delta P_2$,..., $\Delta P_i$ may be determined based on a preset function for a corresponding parameter. A method of determining the variations $\Delta P_1$, $\Delta P_2$,..., $\Delta P_i$ is described with reference to FIGS. 4 to 6.

In an example, the electronic device 100 may generate candidate second value sets 330 by applying the variation set 320 to the first value set 310. For example, the candidate second value sets 330 may include a candidate 2-1 value set 331 in which a value of a first parameter is changed from a first value $P_1$ to a second value $P_1 + \Delta P_1$. For example, the candidate second value sets 330 may include a candidate 2-2 value set 332 in which a value of a second parameter is changed from a first value $P_2$ to a second value $P_2 + \Delta P_2$. For example, the candidate second value sets 330 may include a candidate 2-i value set 333 in which a value of an i-th parameter is changed from a first value $P_i$ to a second value $P_i + \Delta P_i$. In some implementations, more than one value of a second candidate value set may be changed at a time.

FIG. 4 illustrates an example method of generating a candidate second value sets based on preset variations for each of parameters, according to one or more embodiments.

In an example, operation 230 described above with reference to FIG. 2 may include operations 410 and 420 to be described next. Operations 410 and 420 may be performed by the electronic device 100 described above with reference to FIG. 1.

In operation 410, the electronic device 100 may generate a candidate 2-1 value set by changing a first value (corresponding to a first of the parameters) to a second value based on a preset variation for (or associated with) the first parameter.

In operation 420, the electronic device 100 may generate a candidate 2-2 value set by changing a first value of a second of the parameters to a second value based on a preset variation for the second parameter.

In an example, the preset variations may be different from each other. For example, a variation of the first parameter may be set based on a range in which a value of the first parameter may be changed. For example, when changing a value of the first parameter is relatively more difficult than changing a value of the second parameter (or when the simulation is more sensitive to the first parameter), the variation of the first parameter may be set to a lesser amount than the variation of the second parameter.

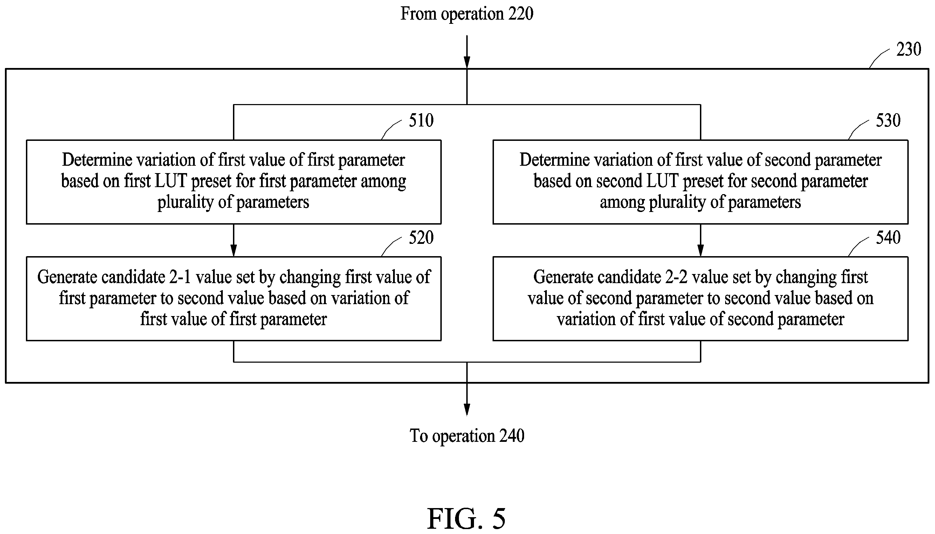

FIG. 5 illustrates an example method of generating candidate second value sets based on variations determined based on a preset LUT for each of parameters, according to one or more embodiments.

In an example, operation 230 described above with reference to FIG. 2 may include operations 510 to 540 to be described next. Operations 510 to 540 may be performed by the electronic device 100 described above with reference to FIG. 1.

In operation 510, the electronic device 100 may determine a variation of a first value of a first parameter based on a first LUT preset for the first parameter among the parameters. The first LUT may be a table in which a range of values of the first parameter is divided into a levels, and a variation is preset for each of the levels. For example, for a parameter in which a value is difficult to be further changed as the value of the parameter increases, the LUT may be preset such that the variation set for a higher level is less than the variation set for a lower level.

In operation 520, the electronic device 100 may generate a candidate 2-1 value set by changing the first value of the first parameter to a second value based on the variation of the first value of the first parameter.

In operation 530, the electronic device 100 may determine a variation of a first value of a second parameter based on a second LUT preset for the second parameter among the parameters. The second LUT may be a table in which a range of values of the second parameter is divided into a levels, and a variation is preset for each of the levels.

In operation 540, the electronic device 100 may generate a candidate 2-2 value set by changing the first value of the second parameter to a second value based on applying the variation of the second parameter to the first value of the second parameter.

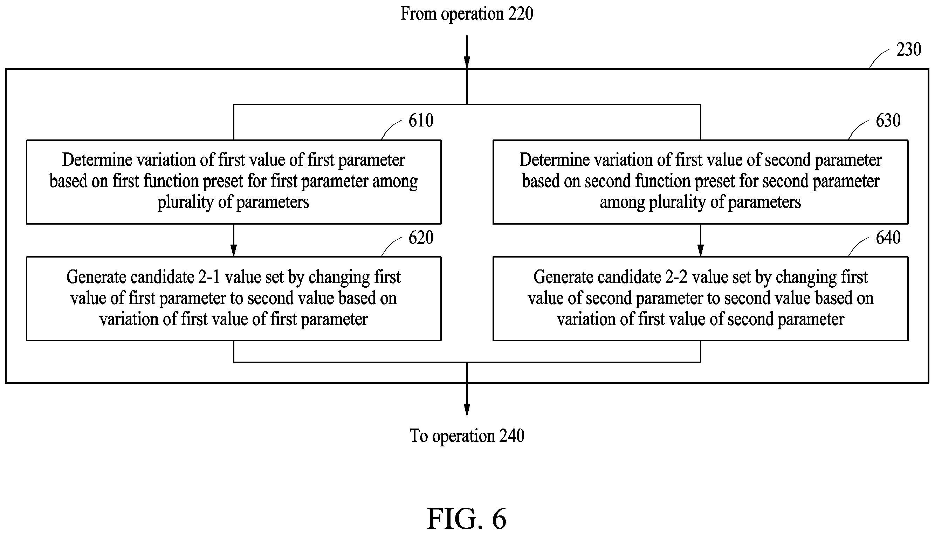

FIG. 6 illustrates an example method of generating candidate second value sets based on variations determined based on a preset function for each of parameters, according to one or more embodiments.

In an example, operation 230 described above with reference to FIG. 2 may include operations 610 to 640 described next. Operations 610 to 640 may be performed by the electronic device 100 described above with reference to FIG. 1.

In operation 610, the electronic device 100 may determine a variation of a first value of a first parameter based on a first function preset for the first parameter among the parameters. The first function may be a function that takes a first value of a first parameter as an input and outputs a variation of the first value as a result. The variation output function may be a continuous function (as opposed to a table-based step function). For example, the variation output function for a parameter in which a value is likely to be further changed as the value of the parameter increases may be in the form of an exponential function. For example, the variation output function for a parameter in which a value is difficult to be further changed as the value of the parameter increases may be in the form of a logarithmic function.

In operation 620, the electronic device 100 may generate a candidate 2-1 value set by changing the first value of the first parameter to a second value based on the variation of the first value of the first parameter computed by the first function.

In operation 630, the electronic device 100 may determine a variation of a first value of a second parameter based on a second function preset for the second parameter among the parameters. The second function may be a function that takes a first value of a second parameter as an input and outputs a variation of the second value as a result.

In operation 640, the electronic device 100 may generate a candidate 2-2 value set by changing the first value of the second parameter to a second value based on the variation of the first value of the second parameter computed by the second function.

FIG. 7 illustrates an example method of determining a second value set of parameters as a default set, according to one or more embodiments.

In an example, when it is determined that the second performance indicator does not correspond to the target performance indicator in operation 260 described above with reference to FIG. 2 (i.e., when none of the candidate second value sets are sufficient with respect to the target performance indicator), operation 710 may be performed.

In operation 710, the electronic device 100 may determine/select one of the second value sets as a new default/initial value set of the parameters.

The second value set selected as the new default value set may be selected based on determining that, although it does not satisfy the target performance indicator, it provides improved performance (of the simulated target battery function) compared to the first value set of the parameters. Accordingly, the electronic device 100 may determine/select that second value set of the parameters as the new default set of values of the parameters. Then, operations 210 to 260 may be re-performed (with the new default/initial value set) to continuously move the values of the value set towards values of the parameters that improve the performance indicator. Performing operations 210 to 260 once may be one iteration of a process for determining optimized values of the parameters. For example, a second value set of the parameters may be determined through a first iteration, a third value set of the parameters may be determined through a second iteration (with the second value set serving as the initial value set), and, generally an n+1th value set of the parameters may be determined through an n-th iteration. When an n+1th performance indicator acquired (by simulation of the target battery operation) for the n+1th value set of the parameters corresponds to (or satisfies) the target performance indicator, the n+1th value set of the parameters may be determined as the final optimized value set of the parameters.

FIG. 8 illustrates example simulation results for an operation of charging a battery at a C-rate of 5C using the parameter variation in Table 1, according to one or more embodiments.

In an example, optimal values of parameters may be determined to improve a charging speed of a battery. For example, a target performance indicator may correspond to charging the battery for 10 minutes at a C-rate of 5C without reaching a voltage limit condition (e.g., 4.43 V) and without reaching an anode potential limit (e.g., 0 V). When the above-described conditions are satisfied, the SoC of the battery may reach 80% within 10 minutes. Example values of parameters affecting the charging speed of a battery are shown expressed as in Table 1 below.

Table 1

| Parameter | First value | First variation | Second variation | Third variation | Fourth variation | Fifth variation |
|---|---|---|---|---|---|---|
| eps_l_a | 0.24 | 0.1 | 0.1 | 0.1 | 0.1 | 0.1 |
| eps_l_s | 0.4 | 0.1 | 0.1 | 0.1 | 0.1 | 0.1 |
| eps_l_c | 0.14 | 0.1 | 0.1 | 0.1 | 0.1 | 0.1 |
| R_f_a_0 | 0.0172 | -0.002 | -0.002 | -0.002 | -0.002 | -0.001 |
| R_f_c_0 | 0.0274 | -0.002 | -0.002 | -0.002 | -0.002 | -0.001 |
| Ds_a | $x10^0$ | $x10^{0.4}$ | $x10^{0.2}$ | $x10^{0.4}$ | $x10^{0.4}$ | $x10^{0.4}$ |
| Ds_c | $x10^0$ | $x10^{0.4}$ | $x10^{0.2}$ | $x10^{0.4}$ | $x10^{0.4}$ | $x10^{0.4}$ |
| k_a | (1.8e-11) x1 | (1.8e-11)x5 | (1.8e-11)x5 | (1.8e-11)x2 | (1. 8e-11)x5 | (1.8e-11)x5 |
| k_c | (5.5e-11) x1 | (5.5e-11)x5 | (5.5e-11)x5 | (5.5e-11)x2 | (5.5e-11)x5 | (5.5e-11)x5 |
| t_plus | 0.39 | 0.1 | 0.1 | 0.1 | 0.05 | 0.1 |
| De | 1 | 1 | 1 | 1 | 0.5 | 0.5 |
| kappa_e | 1 | 1 | 1 | 1 | 1 | 1 |

In Table 1, eps_l_a is a parameter representing a porosity in an anode electrode layer (or a volume fraction of an electrolyte in the anode electrode layer). eps_l_s is a parameter representing a porosity of a separator (or a volume fraction of an electrolyte in the separator). eps_l_c is a parameter representing a porosity in a cathode electrode layer (or a volume fraction of an electrolyte in the electrode layer). R_f_a_0 is a parameter representing a surface film resistance of an anode active material. R_f_c_0 is a parameter representing a surface film resistance of a cathode active material. Ds_a is a parameter representing a diffusion coefficient of lithium-ions in an anode active material. Ds_c is a parameter representing a diffusion coefficient of lithium-ions in a cathode active material. k_a is a parameter representing a lithium-ion reaction rate constant on an anode surface. k_c is a parameter representing a lithium-ion reaction rate constant on a cathode surface. t_plus is a parameter representing a lithium-ion transference number in an electrolyte. De is a parameter representing a diffusion coefficient of lithium-ions in an electrolyte. kappa_e is a parameter representing ionic conductivity of an electrolyte.

The first value of Table 1 may be a default value of the parameters. Iterations (e.g., the first example 810) may be performed to determine optimal values of the parameters based on the first variation values (column) in Table 1. Iterations (e.g., the second example 820) may be performed to determine optimal values of the parameters based on the second variation values (column). Iterations (e.g., the third example 830) may be performed to determine optimal values of the parameters based on the third variation values (column). Iterations (e.g., the fourth example 840) may be performed to determine optimal values of the parameters based on the fourth variation values (column). Iterations (e.g., the fifth example 850) may be performed to determine optimal values of the parameters based on the fifth variation values (column) . Different optimal values of the parameters may be determined by varying the variation values of at least a portion of the corresponding parameters. The results of the above-described first to fifth examples are illustrated with reference to FIG. 8.

FIG. 8 illustrates the iterations of the first to fifth examples in a case where a time (e.g., 10 minutes) until reaching a voltage limit and an anode potential limit when charging a battery at a C-rate of 5C is set as a target performance indicator. The number of iterations performed for each example may be different, but an optimal value set of the parameters was determined after 33 to 43 iterations were performed for each example. The number of simulations performed for the first to fifth examples is about 400 to 500, and the number was $10^8$ to $10^9$ times less than the number of simulations performed for all cases, which was $10^{12}$ times.

In an example, the target performance indicator may be expressed as a combination of a performance factors related to the target performance trait. For example, the performance factors may include a first factor and a second factor. For example, factors related to quick charging of a battery may include a factor for cell voltage and a factor for anode potential. As for the performance indicator for quick charging, the lower the cell voltage and the higher the anode potential, the better the performance indicator may be. For example, when multiple factors are to be considered, the overall performance indicator may be expressed by Equation 1.

Equation 1

$$F = W_v * \Delta V + W_{AP} * \Delta AP$$

In Equation 1, F denotes a performance indicator, $\Delta V$ denotes an integral value of a difference between a cell voltage by a default value set and a cell voltage by a second value set of a parameters as a first factor, $W_v$ denotes a first weight of the first factor, $\Delta AP$ denotes an integral value of a difference between an anode potential by a default set and an anode potential by a second value set of a parameters as a second factor, and $W_{AP}$ denotes a second weight of the second factor.

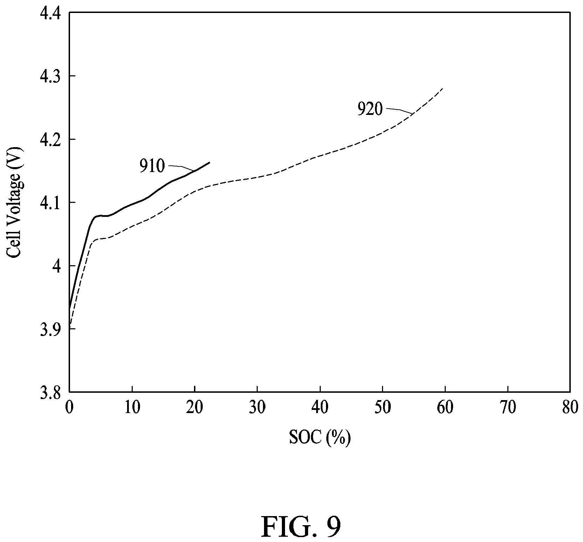

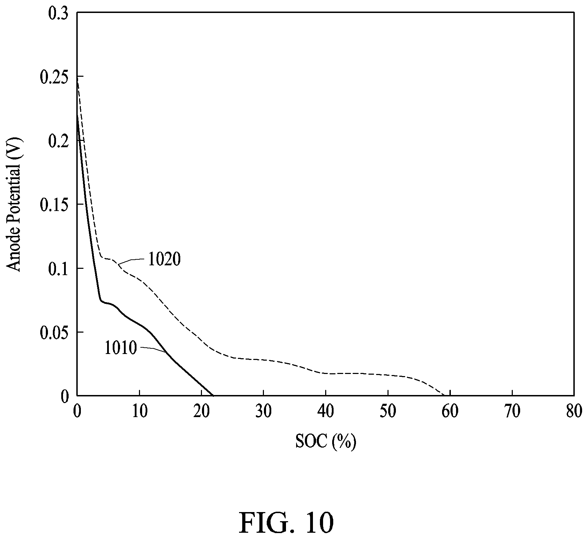

The integral value $\Delta V$ of the difference between the cell voltage according to the default value set and the cell voltage according to the second value set of the parameters is described with reference to FIG. 9. The integral value $\Delta AP$ of the difference between the anode potential according to the default value set and the anode potential according to the second value set of the parameters is described with reference to FIG. 10.

FIG. 9 illustrates an example variation curve of cell voltage as a first factor used to obtain a performance indicator for an operation of charging a battery, according to one or more embodiments.

A first curve 910 represents a cell voltage according to a default value set of the parameters. A second curve 920 represents a cell voltage according to a second value set of the parameters. $\Delta V$ may correspond to an area between the first curve 910 and the second curve 920.

FIG. 10 illustrates an example variation curve of anode potential as a second factor used to obtain a performance indicator for an operation of charging a battery, according to one or more embodiments.

A first curve 1010 represents an anode potential according to a default value set of the parameters. A second curve 1020 represents an anode potential according to a second value set of the parameters. $\Delta AP$ may be an area between the first curve 1010 and the second curve 1020.

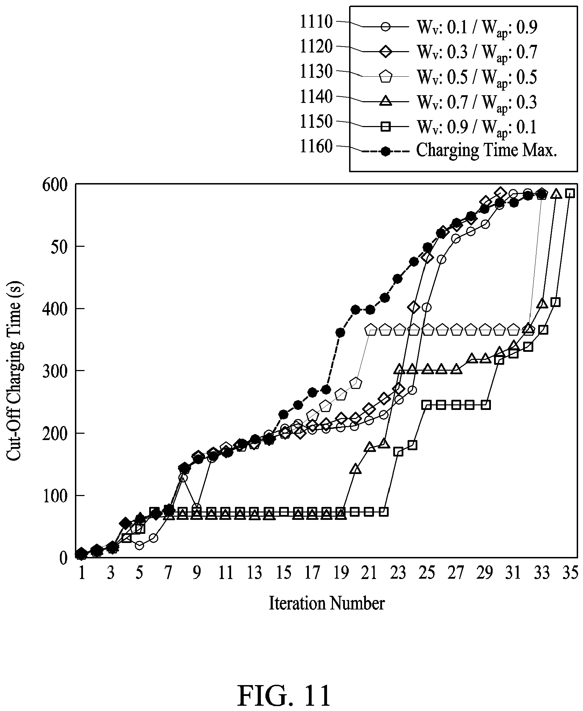

FIGS. 11 to 15 illustrate examples of simulation results of an operation of charging a battery at a C-rate of 5C according to variations of a first weight of a first factor and variations of a second weight of a second factor, according to one or more embodiments. The legends of FIGS. 11 to 15 indicate varying values of the two weights.

Curves 1110 to 1160 in FIG. 11 illustrate simulation results obtained by applying variations of the first weight of the first factor and variations of the second weight of the second factor with respect to the first example 810 described above with reference to FIG. 8.

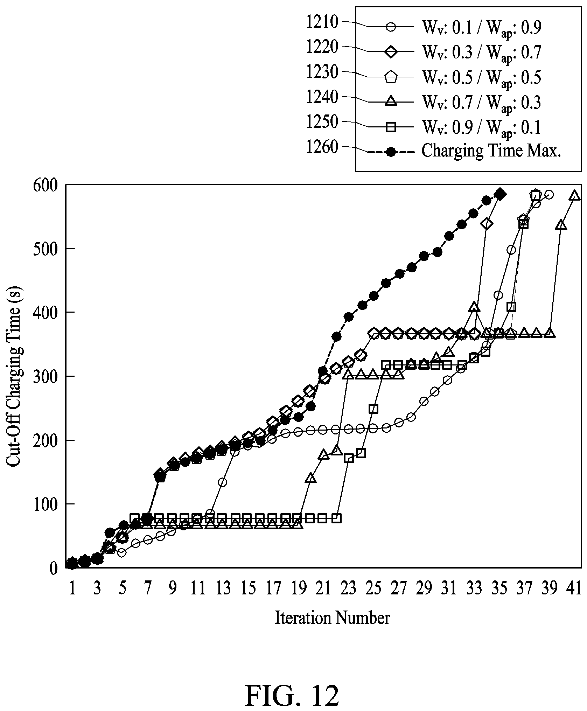

Curves 1210 to 1260 in FIG. 12 illustrate simulation results obtained by applying variations of the first weight of the first factor and variations of the second weight of the second factor with respect to the second example described 820 above with reference to FIG. 8.

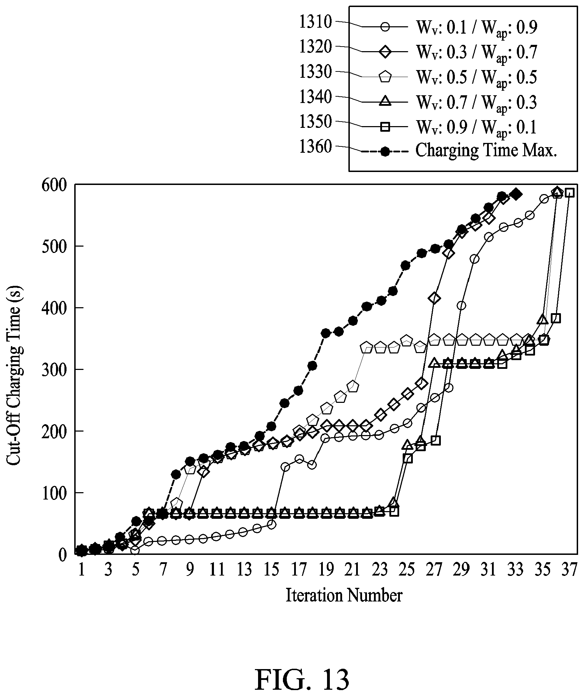

Curves 1310 to 1360 in FIG. 13 illustrate simulation results obtained by applying variations of the first weight of the first factor and variations of the second weight of the second factor with respect to the third example 830 described above with reference to FIG. 8.

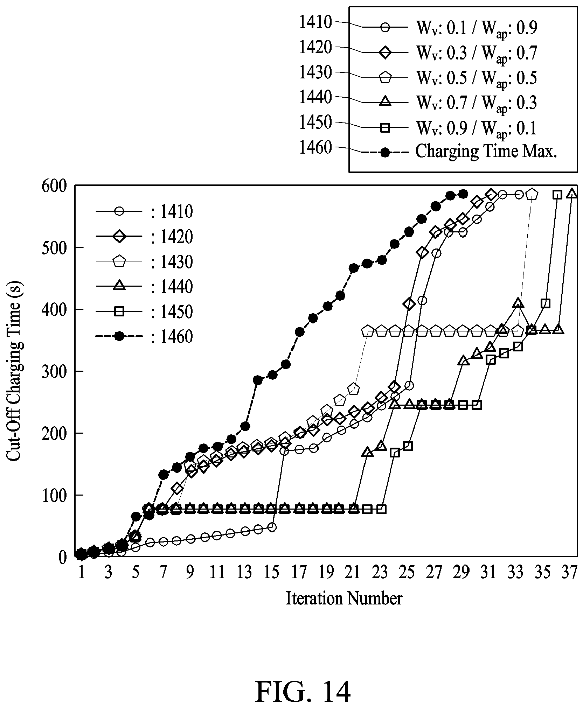

Curves 1410 to 1460 in FIG. 14 illustrate simulation results obtained by applying variations of the first weight of the first factor and variations of the second weight of the second factor with respect to the fourth example 840 described above with reference to FIG. 8.

Curves 1510 to 1560 in FIG. 15 illustrate simulation results obtained by applying variations of the first weight of the first factor and variations of the second weight of the second factor with respect to the fifth example 850 described above with reference to FIG. 8.

According to the simulation results illustrated with reference to FIGS. 11 to 15, the number of iterations to reach the target performance indicator varies according to the first weight of the first factor and the second weight of the second factor.

The computing apparatuses, the vehicles, the electronic devices, the processors, the memories, the image sensors, the vehicle/operation function hardware, the ADAS/AD systems, the displays, the information output system and hardware, the storage devices, and other apparatuses, devices, units, modules, and components described herein with respect to FIGS. 1-11 are implemented by or representative of hardware components. Examples of hardware components that may be used to perform the operations described in this application where appropriate include controllers, sensors, generators, drivers, memories, comparators, arithmetic logic units, adders, subtractors, multipliers, dividers, integrators, and any other electronic components configured to perform the operations described in this application. In other examples, one or more of the hardware components that perform the operations described in this application are implemented by computing hardware, for example, by one or more processors or computers. A processor or computer may be implemented by one or more processing elements, such as an array of logic gates, a controller and an arithmetic logic unit, a digital signal processor, a microcomputer, a programmable logic controller, a field-programmable gate array, a programmable logic array, a microprocessor, or any other device or combination of devices that is configured to respond to and execute instructions in a defined manner to achieve a desired result. In one example, a processor or computer includes, or is connected to, one or more memories storing instructions or software that are executed by the processor or computer. Hardware components implemented by a processor or computer may execute instructions or software, such as an operating system (OS) and one or more software applications that run on the OS, to perform the operations described in this application. The hardware components may also access, manipulate, process, create, and store data in response to execution of the instructions or software. For simplicity, the singular term "processor" or "computer" may be used in the description of the examples described in this application, but in other examples multiple processors or computers may be used, or a processor or computer may include multiple processing elements, or multiple types of processing elements, or both. For example, a single hardware component or two or more hardware components may be implemented by a single processor, or two or more processors, or a processor and a controller. One or more hardware components may be implemented by one or more processors, or a processor and a controller, and one or more other hardware components may be implemented by one or more other processors, or another processor and another controller. One or more processors, or a processor and a controller, may implement a single hardware component, or two or more hardware components. A hardware component may have any one or more of different processing configurations, examples of which include a single processor, independent processors, parallel processors, single-instruction single-data (SISD) multiprocessing, single-instruction multiple-data (SIMD) multiprocessing, multiple-instruction single-data (MISD) multiprocessing, and multiple-instruction multiple-data (MIMD) multiprocessing.

The methods illustrated in FIGS. 1-11 that perform the operations described in this application are performed by computing hardware, for example, by one or more processors or computers, implemented as described above implementing instructions or software to perform the operations described in this application that are performed by the methods. For example, a single operation or two or more operations may be performed by a single processor, or two or more processors, or a processor and a controller. One or more operations may be performed by one or more processors, or a processor and a controller, and one or more other operations may be performed by one or more other processors, or another processor and another controller. One or more processors, or a processor and a controller, may perform a single operation, or two or more operations.

Instructions or software to control computing hardware, for example, one or more processors or computers, to implement the hardware components and perform the methods as described above may be written as computer programs, code segments, instructions or any combination thereof, for individually or collectively instructing or configuring the one or more processors or computers to operate as a machine or special-purpose computer to perform the operations that are performed by the hardware components and the methods as described above. In one example, the instructions or software include machine code that is directly executed by the one or more processors or computers, such as machine code produced by a compiler. In another example, the instructions or software includes higher-level code that is executed by the one or more processors or computer using an interpreter. The instructions or software may be written using any programming language based on the block diagrams and the flow charts illustrated in the drawings and the corresponding descriptions herein, which disclose algorithms for performing the operations that are performed by the hardware components and the methods as described above.

The instructions or software to control computing hardware, for example, one or more processors or computers, to implement the hardware components and perform the methods as described above, and any associated data, data files, and data structures, may be recorded, stored, or fixed in or on one or more non-transitory computer-readable storage media. Examples of a non-transitory computer-readable storage medium include read-only memory (ROM), random-access programmable read only memory (PROM), electrically erasable programmable read-only memory (EEPROM), random-access memory (RAM), dynamic random access memory (DRAM), static random access memory (SRAM), flash memory, non-volatile memory, CD-ROMs, CD-Rs, CD+Rs, CD-RWs, CD+RWs, DVD-ROMs, DVD- Rs, DVD+Rs, DVD-RWs, DVD+RWs, DVD-RAMs, BD-ROMs, BD-Rs, BD-R LTHs, BD-REs, blue-ray or optical disk storage, hard disk drive (HDD), solid state drive (SSD), flash memory, a card type memory such as multimedia card micro or a card (for example, secure digital (SD) or extreme digital (XD)), magnetic tapes, floppy disks, magneto-optical data storage devices, optical data storage devices, hard disks, solid-state disks, and any other device that is configured to store the instructions or software and any associated data, data files, and data structures in a non-transitory manner and provide the instructions or software and any associated data, data files, and data structures to one or more processors or computers so that the one or more processors or computers can execute the instructions. In one example, the instructions or software and any associated data, data files, and data structures are distributed over network-coupled computer systems so that the instructions and software and any associated data, data files, and data structures are stored, accessed, and executed in a distributed fashion by the one or more processors or computers.

While this disclosure includes specific examples, it will be apparent after an understanding of the disclosure of this application that various changes in form and details may be made in these examples without departing from the scope of the claims. The examples described herein are to be considered in a descriptive sense only, and not for purposes of limitation. Descriptions of features or aspects in each example are to be considered as being applicable to similar features or aspects in other examples. Suitable results may be achieved if the described techniques are performed in a different order, and/or if components in a described system, architecture, device, or circuit are combined in a different manner, and/or replaced or supplemented by other components or their equivalents.

Therefore, in addition to the above disclosure, the scope of the invention is defined by the enclosed claims.

**Claims**

1. A method of determining an optimized value set of parameters used for a target operation of a battery, the method comprising:

    setting, as a default value set, a first value set comprising first values of the respective parameters;
    acquiring a first performance indicator by performing a simulation of the target operation according to the first value set;
    generating candidate second value sets, each candidate second value set having at least one value in the first value set changed based on the first value set;
    acquiring second performance indicators respectively corresponding to the candidate second value sets by performing simulations of the target operation according to the respective candidate second value sets;
    selecting one of the candidate second value sets as a second value set based on the second performance indicators;
    determining whether the second performance indicator corresponding to the second value set satisfies a target performance condition of the battery; and
    in response to determining that the second performance indicator satisfies the target performance condition of the battery, using the second value set as the optimized value set of the parameters.

2. The method of claim 1, wherein the acquiring of the first performance indicator comprises performing the simulation of the target operation by applying the first value set to a battery model representing an internal state of the battery.

3. The method of claim 1 or 2, wherein the target operation is an operation of charging the battery, and wherein the target performance condition comprises any one or any combination of a charging capacity of the battery or a charging speed of the battery.

4. The method of one of claims 1 to 3, wherein the generating of the candidate second value sets comprises:

    generating a first second candidate value set by changing a first value of a first of the parameters to a second value based on a preset variation for the first parameter; and

generating a second second candidate value set by changing a first value of a second of the parameters to a second value based on a preset variation for the second parameter.

5. The method of one of claims 1 to 4, wherein the generating of the candidate second value sets comprises:

determining a variation of the first value of the first parameter based on a first lookup table, LUT, preset for the first parameter;
generating a first second candidate value set by changing the first value of the first parameter to a second value based on the variation of the first value of the first parameter;
determining a variation of the first value of the second parameter based on a second LUT preset for the second parameter among the parameters; and
generating a second second candidate value set by changing the first value of the second parameter to a second value based on the variation of the first value of the second parameter, or
wherein the generating of the candidate second value sets comprises:

determining a variation of the first value of the first parameter based on a first function preset for the first parameter;
generating a first second candidate value set by changing the first value of the first parameter to a second value based on the variation of the first value of the first parameter;
determining a variation of the first value of the second parameter based on a second function preset for the second parameter among the parameters; and
generating a second second candidate value set by changing the first value of the second parameter to a second value based on the variation of the first value of the second parameter.

6. The method of one of claims 1 to 5, wherein the acquiring of the first performance indicator comprises acquiring the first performance indicator based on a result value of a first factor of the simulation, a first weight of the first factor, a result value of a second factor of the simulation, and a second weight of the second factor.

7. The method of one of claims 1 to 6, further comprising, in response to the second performance indicator not satisfying the target performance condition, setting the second value set as a new default set of the parameters.

8. An electronic device for determining an optimized value set of parameters used for a target operation of a battery, comprising:

one or more processors; and
a memory storing instructions configured to cause the one or mor processors to:

access simulation data for preset charging currents that is based on a battery model representing an internal state of the battery;
set a first value set as a default value set of the parameters;
acquire a first performance indicator by performing a simulation of the target operation of the battery based on the first value set and the simulation data;
generate a candidate second value sets in which at least one value in the first value set is changed based on the first value set;
acquire candidate second performance indicators by performing simulations of the target operation of the battery based on the respective candidate second value sets and the simulation data;
determine one of the candidate second value sets as a second value set of the parameters based on the candidate second performance indicators;
determine whether the second performance indicator for the second value set of the parameters corresponds to a preset target performance indicator; and
in response to the second performance indicator corresponding to the target performance indicator, determine the second value set to be the optimized value set of the parameters.

9. The electronic device of claim 8, wherein the target operation is an operation of charging the battery, and wherein the target performance indicator comprises any one or any combination of a charging capacity of the battery or a charging speed of the battery.

10. The electronic device of claim 8 or 9, wherein the generating of the candidate second value sets comprises:

generating a first second candidate value set by changing a first value of a first of the parameter to a second value based on a preset variation for the first parameter; and

generating a candidate second second value set by changing a first value of a second of the parameters to a second value based on a preset variation for the second parameter, and

wherein the preset variation for the first parameter and the preset variation for the second parameter comprise different respective values.

11. The electronic device of one of claims 8 to 10, wherein the generating of the candidate second value sets comprises:

determining a variation of the first value of the first parameter based on a first lookup table, LUT, preset for the first parameter;

generating a first second candidate value set by changing the first value of the first parameter to a second value based on the variation of the first value of the first parameter;

determining a variation of the first value of the second parameter based on a second LUT preset for the second parameter; and

generating a second second candidate value set by changing the first value of the second parameter to a second value based on the variation of the first value of the second parameter, or

wherein the generating of the candidate second value sets comprises:

determining a variation of the first value of the first parameter based on a first function preset for the first parameter;

generating a first second candidate value set by changing the first value of the first parameter to a second value based on the variation of the first value of the first parameter;

determining a variation of the first value of the second parameter based on a second function preset for the second parameter; and

generating a second second candidate value set by changing the first value of the second parameter to a second value based on the variation of the first value of the second parameter.

12. The electronic device of one of claims 8 to 11, wherein the acquiring of the first performance indicator is based on a result value of a first factor of the simulation, a first weight of the first factor, a result value of a second factor of the simulation, and a second weight of the second factor.

13. The electronic device of one of claims 8 to 12, wherein the instructions are further configured to cause the one or more processors to:

in response to the second performance indicator not corresponding to the target performance indicator, set the second value set as the default set of the parameters, and

generate new candidate second value sets in which at least one value in the first value set is changed based on the first value set.

14. A computer-readable storage medium having instructions that, when executed by one or more processors, cause the one or more processor to perform the steps of:

forming a first battery parameter values set;

generating first permutation sets comprising respective permutations of the first battery parameter values set;

obtaining first performance indications generated by respective simulations of an internal state of a battery based on the respective first permutation sets;

based on the first performance indications, determining that none of the first permutation sets satisfy a performance condition of a charging operation of the battery, and based thereon, generating second permutations sets comprising respective permutations of one of the first permutation sets;

obtaining second performance indications generated by respective simulations of the internal state of the battery based on the respective second permutation sets; and

selecting one of the second permutation sets based on its corresponding second performance indication, and using the selected second permutation set to control a charging operation of the battery.

15. The computer-readable storage medium of claim 14 further comprising instructions to cause the one or more processors to select the one of the second permutation sets based on having the highest corresponding second performance indication.

FIG. 1

EP 4 391 286 A1

```
                          ┌──────────────┐
                          │    Start     │
                          └──────┬───────┘
                                 │                      ┌─ 210
   ┌─────────────────────────────▼──────────────────────────────┐
   │       Set first value set as default set of plurality of parameters       │
   └─────────────────────────────┬──────────────────────────────┘
                                 │                      ┌─ 220
   ┌─────────────────────────────▼──────────────────────────────┐
   │     Acquire first performance indicator by performing simulation for       │
   │        target operation of battery based on first value set                │
   └─────────────────────────────┬──────────────────────────────┘
                                 │                      ┌─ 230
   ┌─────────────────────────────▼──────────────────────────────┐
   │   Generate plurality of candidate second value sets in which at least      │
   │    one value in first value set is changed based on first value set        │
   └─────────────────────────────┬──────────────────────────────┘
                                 │                      ┌─ 240
   ┌─────────────────────────────▼──────────────────────────────┐
   │     Acquire plurality of candidate second performance indicators by        │
   │     performing simulation for target operation of battery based on         │
   │              plurality of candidate second value sets                      │
   └─────────────────────────────┬──────────────────────────────┘
                                 │                      ┌─ 250
   ┌─────────────────────────────▼──────────────────────────────┐
   │   Determine one of plurality of candidate second value sets as second      │
   │    value set of plurality of parameters based on plurality of candidate    │
   │                  second performance indicators                             │
   └─────────────────────────────┬──────────────────────────────┘
                                 │                      ┌─ 260
   ┌─────────────────────────────▼──────────────────────────────┐
   │   Determine whether second performance indicator for second value set      │
   │  of plurality of parameters corresponds to target performance indicator    │
   └─────────────────────────────┬──────────────────────────────┘
                                 │                      ┌─ 270
   ┌─────────────────────────────▼──────────────────────────────┐
   │  When second performance indicator corresponds to target performance       │
   │      indicator, determine second value set as optimal value set of         │
   │                    plurality of parameters                                 │
   └─────────────────────────────┬──────────────────────────────┘
                                 │
                          ┌──────▼───────┐
                          │     End      │
                          └──────────────┘
```

# FIG. 2

FIG. 3

From operation 220

230

410

Generate candidate 2-1 value set by changing first value of first parameter among plurality of parameters to second value based on preset variation for first parameter

420

Generate candidate 2-2 value set by changing first value of second parameter among plurality of parameters to second value based on preset variation for second parameter

To operation 240

# FIG. 4

From operation 220

230

510
Determine variation of first value of first parameter based on first LUT preset for first parameter among plurality of parameters

530
Determine variation of first value of second parameter based on second LUT preset for second parameter among plurality of parameters

520
Generate candidate 2-1 value set by changing first value of first parameter to second value based on variation of first value of first parameter

540
Generate candidate 2-2 value set by changing first value of second parameter to second value based on variation of first value of second parameter

To operation 240

FIG. 5

EP 4 391 286 A1

From operation 220

230

610
Determine variation of first value of first parameter based on first function preset for first parameter among plurality of parameters

630
Determine variation of first value of second parameter based on second function preset for second parameter among plurality of parameters

620
Generate candidate 2-1 value set by changing first value of first parameter to second value based on variation of first value of first parameter

640
Generate candidate 2-2 value set by changing first value of second parameter to second value based on variation of first value of second parameter

To operation 240

FIG. 6

EP 4 391 286 A1

From operation 260

To operation 210

Does second performance indicator correspond to target performance indicator? — No → Determine second value set as default set of plurality of parameters — 710

Yes

To operation 270

FIG. 7

FIG. 8

FIG. 9

FIG. 10

FIG. 11

FIG. 12

FIG. 13

FIG. 14

FIG. 15

Europäisches
Patentamt

European
Patent Office

Office européen
des brevets

# EUROPEAN SEARCH REPORT

**Application Number**

EP 23 18 9080

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 4 099 534 A1 (SAMSUNG ELECTRONICS CO LTD [KR]) 7 December 2022 (2022-12-07) | 1-5, 7-11, 13-15 | INV. H02J7/00 |
| Y | * figures 3,7,9 * <br> * paragraph [0005] * <br> * paragraph [0014] * <br> * paragraph [0046] * <br> ----- | 6,12 | |
| Y | US 10 886 767 B2 (SAMSUNG ELECTRONICS CO LTD [KR]) 5 January 2021 (2021-01-05) <br> * column 11, line 7 - line 19 * <br> ----- | 6,12 | |
| A | US 11 139 668 B2 (SAMSUNG ELECTRONICS CO LTD [KR]) 5 October 2021 (2021-10-05) <br> * figures 2,3 * <br> ----- | 1,8,14 | |
| A | US 10 797 501 B2 (SAMSUNG ELECTRONICS CO LTD [KR]) 6 October 2020 (2020-10-06) <br> * figures 3, 5 * <br> * column 2, line 15 - line 24 * <br> ----- | 1,8,14 | |

**TECHNICAL FIELDS SEARCHED (IPC)**

H02J

The present search report has been drawn up for all claims

| Place of search | Date of completion of the search | Examiner |
|---|---|---|
| Munich | 30 January 2024 | Despis, Enguerran |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 23 18 9080

This annex lists the patent family members relating to the patent documents cited in the above-mentioned European search report.
The members are as contained in the European Patent Office EDP file on
The European Patent Office is in no way liable for these particulars which are merely given for the purpose of information.

30-01-2024

| Patent document cited in search report | | Publication date | Patent family member(s) | | Publication date |
|---|---|---|---|---|---|
| EP 4099534 | A1 | 07-12-2022 | CN | 115483728 A | 16-12-2022 |
| | | | EP | 4099534 A1 | 07-12-2022 |
| | | | KR | 20220161778 A | 07-12-2022 |
| | | | US | 2022381830 A1 | 01-12-2022 |
| US 10886767 | B2 | 05-01-2021 | EP | 3525313 A1 | 14-08-2019 |
| | | | KR | 20190097626 A | 21-08-2019 |
| | | | US | 2019252898 A1 | 15-08-2019 |
| | | | US | 2021119464 A1 | 22-04-2021 |
| US 11139668 | B2 | 05-10-2021 | KR | 20200037592 A | 09-04-2020 |
| | | | US | 2020103469 A1 | 02-04-2020 |
| | | | US | 2022014026 A1 | 13-01-2022 |
| US 10797501 | B2 | 06-10-2020 | KR | 20190074123 A | 27-06-2019 |
| | | | US | 2019190277 A1 | 20-06-2019 |
| | | | US | 2020403417 A1 | 24-12-2020 |

EPO FORM P0459

For more details about this annex : see Official Journal of the European Patent Office, No. 12/82